## Europäisches Patentamt

## European Patent Office

## Office européen des brevets

(11) Veröffentlichungsnummer: **0 146 720**

**B1**

(12)

# EUROPÄISCHE PATENTSCHRIFT

(45) Veröffentlichungstag der Patentschrift:
03.02.88

(21) Anmeldenummer: 84112822.6

(22) Anmeldetag: 24.10.84

(51) Int. Cl.⁴: **G 01 R 27/02,** H 01 C 17/12, H 01 H 21/66, C 23 C 14/54

(54) Verfahren zur Messung des elektrischen Widerstandes von unter dem Einfluss eines Plasmas hergestellten, dünnen, metallischen Schichten während ihrer Herstellung.

(30) Priorität: 10.11.83 DE 3340719

(43) Veröffentlichungstag der Anmeldung:
03.07.85 Patentblatt 85/27

(45) Bekanntmachung des Hinweises auf die Patenterteilung:
03.02.88 Patentblatt 88/5

(84) Benannte Vertragsstaaten:
AT CH DE FR GB IT LI

(73) Patentinhaber: Siemens Aktiengesellschaft Berlin und München, Wittelsbacherplatz 2, D-8000 München 2 (DE)

(72) Erfinder: Hieber, Konrad, Dr. rer. nat., Laubensteinstrasse 7, D-8214 Bernau (DE)
Erfinder: Mayer, Norbert, Dr. rer. nat., Werdenfelsstrasse 77, D-8000 München 70 (DE)

(56) Entgegenhaltungen:
EP-A-0 067 432

SIEMENS FORSCHUNGS- UND ENTWICKLUNGSBERICHTE, Band 11, Nr. 6, 1982, Würzburg; N.M. MAYER "Resistance measurements by radio telemetric system during film deposition by sputtering", Seiten 322-326
IBM TECHNICAL DISCLOSURE BULLETIN, Band 24, Nr. 5, Oktober 1981; P.H. SMITH "Method of controlling film sheet resistance and temperature coefficient of resistance", Seiten 2550-2551
IBM TECHNICAL DISCLOSURE BULLETIN, Band 19, Nr. 2, Juli 1976; H. BOHLEN et al. "Contactless electric testing of conductors", Seiten 539-540

## Beschreibung

Die Erfindung betrifft ein Verfahren zur Messung des elektrischen Widerstandes von unter dem Einfluß eines Plasmas hergestellten, dünnen, metallischen Schichten während ihrer Herstellung durch eine Gleichstromwiderstandsmessung nach dem Prinzip der Zweipunkt- oder Vierpunkt-Meßmethode. Die Patentanmeldung betrifft außerdem Anwendungen der Meßverfahren.

Wie aus einem Aufsatz von Hieber und Mayer aus Thin Solid Films, 90 (1982), Seiten 43 bis 50 bekannt ist, macht es die Messung des elektrischen Widerstandes von metallischen Schichten während der Schichtherstellung möglich, bereits während der Schichtherstellung Änderungen von Struktur, Legierungszusammensetzung und/oder Gefüge festzustellen.

In der Fertigung, zum Beispiel für Leiterbahnen in der Halbleitertechnologie werden metallische Schichten meist in Kathodenzerstäubungsanlagen (Sputteranlagen) mit Vakuumschleusen hergestellt. Während der Beschichtung werden die zu beschichtenden Halbleiterkristall-Substrate ständig unter einem oder mehreren Sputtertargets hin und her bewegt bzw. gedreht. Eine Vorrichtung, die es ermöglicht, den elektrischen Widerstand von Schichten während der Herstellung in Kathodenzerstäubungsanlagen (Sputteranlagen) mit Vakuumschleuse und bewegter (drehbarer) Substratpalette zu messen, ist in den Siemens-Forschungs- und Entwicklungsberichten Band 11 (1982), Nr. 6, auf den Seiten 322 bis 326 in einen Aufsatz von N. M. Mayer und der europäischen Patentanmeldung 0 067 432 beschrieben. Hierbei ist die Widerstandsmeßeinrichtung mit Meßdatenübertragungssystem auf der den Kathodenzerstäubungsplasma (Sputterplasma) abgewandten Seite der Substratpalette montiert. Die Widerstandsmessung erfolgt mit der bekannten Vierpunkt-Meßmethode bei Gleichstrom. Die gemessenen Widerstände werden per Funk aus dem Beschichtungsraum an einen Empfänger außerhalb der Sputteranlage übertragen und von dort an einen Rechner zur Datenspeicherung und Auswertung übergeben.

Messungen mit dieser Meßapparatur an Tantal-Schichten während der Herstellung mit einem DC-Magnetron sind aus den bereits zitierten Siemens-Forschungs- und Entwicklungsberichten Band 11 (1982) Nr. 6, Seiten 322 bis 326, zu entnehmen.

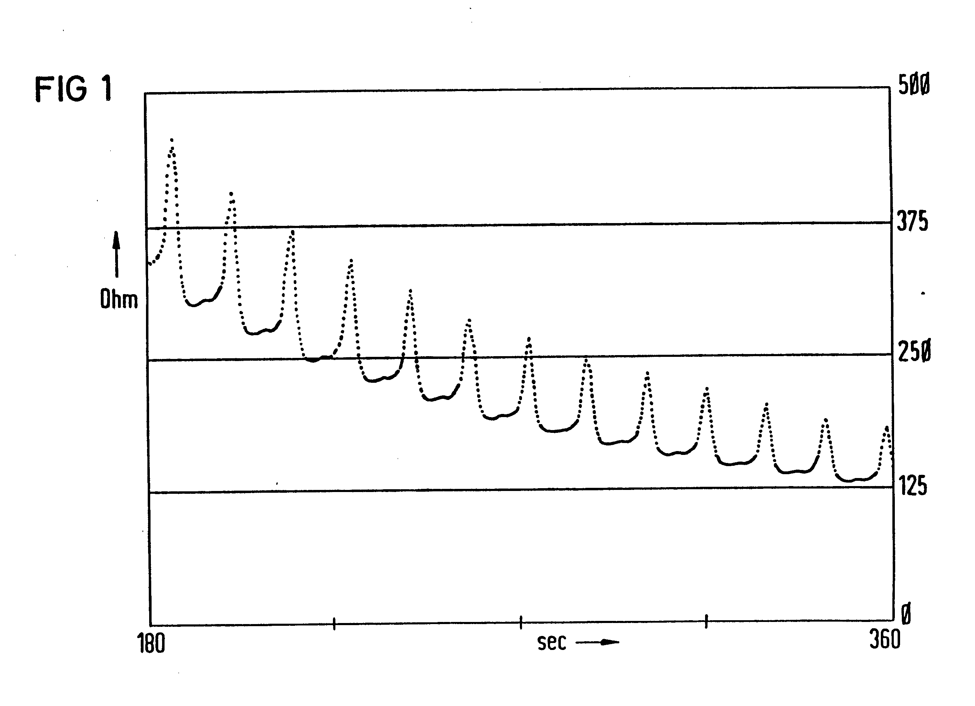

Wird der elektrische Schichtwiderstand in Abhängigkeit von der Zeit gemessen, so erniedrigt sich der Widerstand stufenförmig mit jedem Aufstäuben einer neuen Schichtlage. Dazu wird auf Figur 1 verwiesen, welche in einem Diagramm den Widerstandsverlauf in Abhängigkeit von der Zeit beim lagenweisen Beschichten eines Substrates mit Tantal beim HF-Dioden-Sputtern darstellt. Als Ordinate ist der Widerstand in Ohm, als Abszisse die Sputterzeit in sec aufgetragen. Kommt die Schicht jedoch in die Nähe des Sputtertargets und somit in den Einflußbereich des für das Kathodenzerstäuben notwendigen Plasmas, wird der gemessene elektrische Widerstand verfälscht. In Figur 1 ist dies sichtbar durch die Spitzen an jeder Stufe. Die Ausdehnung, Lage und der Energieinhalt des Sputterplasmas im Beschichtungsraum hängt von den Sputterbedingungen, der Sputtermethode (das heißt Sputtern von zwei oder mehreren Targets gleichzeitig (Co-Sputtern) in den Moden HF (Hochfrequenz)-Sputtern und/oder DC (Gleichstrom)-Sputtern mit oder ohne Magnetron) und der Sputterleistung ab. Die Beeinflussung der elektrischen Messungen ist besonders groß beim HF-Sputtern oder beim Sputtern von mehreren Targets gleichzeitig, wo es zum Teil nicht mehr möglich ist, den elektrischen Widerstand der Schicht ohne Beeinflussung durch das Plasma während einer Palettenumdrehung zu messen, da das Sputterplasma sich über den gesamten Beschichtungsraum ausdehnt, während sich das Plasma beim DC-Sputtern von einem Target bei geringer Leistung nur in der Nähe des Targets befindet.

Aufgabe der Erfindung ist es, Verfahren anzugeben, mit dem der elektrische Widerstand von dünnen metallischen Schichten in einer Sputteranlage während der Beschichtung gemessen werden kann, das heißt, während die Schicht sich im Sputterplasma oder sogar direkt unter dem Sputtertarget befindet. Hierbei soll es unerheblich sein, ob die Schicht unter dem Target hindurchbewegt wird oder unter dem Target stationär liegt. Eine weitere Aufgabe der Erfindung ist es, diese Meßverfahren zu verwenden, um die Herstellung von dünnen Schichten besser überwachen zu können.

Die Erfindung geht dabei von folgender Überlegung aus:

Beim Sputtern werden Argon-Atome ionisiert und gegen das Target beschleunigt. Beim Aufprall der Argon-Ionen auf dem Target werden Atome und/oder Ionen des zu beschichtenden Materials aus dem Target losgeschlagen, die auf dem sich unter dem Target befindlichen Substrat auftreffen. Auf dem Substrat oder der zu messenden Schicht treffen demnach Atome des zu beschichtenden Materials teils als neutrale Teilchen, teils als Ionen, Argon-Ionen sowie Elektronen auf. Einzelheiten dazu sind zu entnehmen aus: Aufsätze von Teer und Delcea und von Pitt in Proceedings of Conference "Ion Plating and Allied Techniques", Edinburg Juni 1977, Seiten 58 bis 69 bzw. Seiten 149 bis 156, sowie dem Aufsatz von Johnson in Solid State Technolgie, April 1983, Seiten 191 bis 195 und dem Aufsatz von Bojarczuk aus J. Vac. Sci. Technol. 18 (3), April 1981 Seiten 890 bis 894.

Die elektrisch nicht neutralen Teilchen injizieren in die Schicht einen Strom. Wird nun der elektrische Widerstand dieser Schicht durch ein Gleichstromverfahren (Zweipunkt- oder Vierpunkt-Meßmethode) gemessen, so überlagert sich der Meßstrom $I_M$ noch der injizierte Strom $I_{inj}$ und verfälscht somit die über die Schicht abfallende Spannung $U_M$ und nach dem Ohmschen Gesetz den gemessenen Widerstand $R_M$ der Schicht.

Diese Erkenntnisse macht sich die Erfindung zunutze. Die Lösungen der Aufgaben sind im Kennzeichen der Ansprüche 1, 2 und 6, 7 angegeben. Vorteilhafte Ausgestaltungen enthalten die Ansprüche 3 bis 5.

Die zweite Lösung betrifft ein Meßverfahren der eingangs genannten Art, das dadurch gekennzeichnet ist, daß der elektrische Widerstand oder der Spannungsabfall über die Schicht bei mindestens zwei unterschiedlichen Meßströmen $I_{M1}$ und $I_{M2}$ bekannter Größe bestimmt wird, wobei die Meßströme $I_{M1}$, $I_{M2}$ entsprechend dem Schichtwiderstand gewählt werden und die Differenz zwischen den verwendeten Meßströmen im Bereich des Verhältnisses 2 bis 100 gewählt wird. Bevorzugt ist ein Verhältnis von etwa 10 zwischen den Meßströmen ($I_{M1}/I_{M2} \approx 10$ für $I_{M1} > I_{M2}$) um den wahren Schichtwiderstand möglichst genau zu ermitteln.

Die Tabelle 1 gibt eine Übersicht über die verwendeten Meßströme.

| Schichtwiderstands-bereich Ω | typische Meß-ströme | Verwendete Meß-ströme im Test |
|---|---|---|
| größer 10 000 | kleiner 100μA | |
| 10 000 - 1 000 | 50 μA - 1 mA | 100 μA |
| 1 000 - 100 | 10 μA - 5 mA | 1 mA, 100 μA |
| 100 - 10 | 100 μA - 10 mA | 5 mA, 1 mA, 100 μA |
| 10 - 1 | 1 mA - 20 mA | 2 mA, 5 mA, 1 mA |
| kleiner 1 | größer 10 mA | 20 mA |

Es liegt im Rahmen der Erfindung, daß die Messungen (bei den beiden Lösungen) in einem Zeitintervall von 0,01 bis 1 sec., vorzugsweise in einem Zeitintervall von 0,2 sec. durchgeführt werden. Das Zeitintervall für die beiden Messungen muß so gewählt werden, daß sich der Schichtwiderstand infolge des Aufsputterns oder infolge des Einbaus anderer Fremdatome in die Schicht nur geringfügig ändern kann ($AR < 1\,\%$, am besten $< 0,1\%$). Die Meßströme müssen entsprechend dem Schichtwiderstand gewählt werden (siehe Tabelle 1). Die Größe der zu messenden injizierten Spannung $U_{inj}$ hängt vom Schichtwiderstand, der Sputtermethode (HF und/oder DC mit oder ohne Magnetron) und der Sputterleistung, das heißt der Energiedichte des Sputterplasmas ab.

Aus der Messung des Schichtwiderstandes $R_M$ und der injizierten Spannung $U_{inj}$ ergibt sich der wahre Schichtwiderstand $R_W$ wie folgt:

Aus

$$R_M = \frac{U_M}{I_M}$$

$$U_{inj} = R_W \cdot I_{inj}$$

$$R_W = \frac{U_M}{I_M + I_{inj}}$$

ergibt sich für die <u>erste Lösung</u>:

$$R_W = \frac{R_M \cdot I_M - U_{inj}}{I_M} \quad (I)$$

Folgende Beziehungen ergeben sich für die zweite Lösung:

<u>a) Verwendung von 2 bekannten Meßströmen</u>

Der wahre Widerstandswert $R_W$ ergibt sich aus den beiden gemessenen Widerständen $R_{M1}$ und $R_{M2}$, die bei den beiden Meßströmen $I_{M1}$ und $I_{M2}$ erhalten werden:

$$\text{Nach (I): } R_W = \frac{R_{M1} \cdot I_{M1} - U_{inj}}{I_{M1}}$$

$$RW = \frac{R_{M2} \cdot I_{M2} - U_{inj}}{I_{M2}}$$

Voraussetzungen: $I_{M1} \neq I_{M2}$ und $I_{M1}, I_{M2} \neq 0$

Bevorzugt ist: $I_{M1}, I_{M2} > 0$ oder $I_{M1}, I_{M2} \neq 0$, das heißt, die Stromrichtung ist in jedem Falle gleich.

Ergibt sich für den 2. Lösungsweg:

$$R_W = \frac{R_{M1} \cdot I_{M1} - R_{M2} \cdot I_{M2}}{I_{M1} - I_{M2}}$$

<u>b) Verwendung von mehr als 2 bekannten Meßströmen</u>

Zur Erhöhung der Genauigkeit ist es möglich, mehr als zwei Meßströme zu verwenden. Der wahre Widerstand $R_W$ wird dann als Mittelwert aus den errechneten Werten $R_{W_{i,j}}$ gemäß Formel (II) ermittelt, wobei alle Meßströme miteinander gekoppelt werden:

zum Beispiel für 3 Meßströme:

3

$$R_{Wi,j} = \frac{R_{Mi} \cdot I_{Mi} - R_{Mj} I_{Mj}}{I_{Mi} - I_{Mj}}$$

mit $R_{W1,2}, R_{W1,3}$ und $R_{W2,3}$ folgt:

$$R_W = \frac{R_{W12} + R_{W13} + R_{W23}}{3}$$

### c) Kombination von Lösung 1 und 2

Es ist auch eine Kombination der beiden Lösungswege 1 und 2 denkbar, nämlich die Messung des elektrischen Widerstandes bei zwei bekannten Meßströmen sowie die Messung der injizierten Spannung.

Über die Meßstromwahl sowie die Zeit, innerhalb der die Messungen durchgeführt werden sollen, gilt das oben bereits genannte.

$R_W$ ermittelt sich dann ebenfalls als Mittelwert der Ergebnisse aus den Lösungswegen 1 und 2. Wie die Beispiele zeigen ist das Verfahren unabhängig von der Sputtermethode, Sputterleistung, dem verwendeten Material oder der Umdrehungsgeschwindigkeit der Palette.

Es ist möglich, durch die Meßverfahren nach der Lehre der Erfindung den wahren Schichtwiderstand im Sputterplasma zu ermitteln. Neben den Möglichkeiten, den so erhaltenen Widerstandswert für eine dynamische Steuerung des Aufdampfprozesses zu verwenden, wie er beispielsweise in der DE-OS 30 04 149 beschrieben ist, sind folgende weitere Anwendungsmöglichkeiten von technischem Interesse:

Aus dem bekannten wahren Schichtwiderstand kann man den in die Schicht durch das Sputterplasma injizierten Strom ermitteln:

$$(III) \quad I_{inj} = \frac{I_M (R_M - R_W)}{R_W}$$

Im Gegensatz zur injizierten Spannung $U_{inj}$ hängt der injizierte Strom nicht vom Schichtwiderstand ab, sondern hängt nur von der Energiedichte des Sputterplasmas ab. Die Energiedichte wiederum wird vom Material, das aufgestäubt wird, der Sputtermethode (HF-, DC- jeweils mit oder ohne Magnetron und in Kombination) und der Targetspannung beeinflußt. Ändert sich nun die Sputterrate während der Beschichtung (Material und Sputtermethode sind hierbei konstant), was meist die Folge einer Änderung der Targetspannung ist, so äußert sich dies in einer Änderung von $I_{inj}$.

Es ist somit möglich, während des Beschichtungsprozesses Änderungen in der Sputterrate meßtechnisch über eine Bestimmung des in die Schicht injizierten Stromes zu erfassen.

Änderungen in der Sputterrate bzw. dem injizierten Strom können örtlich und/oder zeitlich auftreten.

### a) Örtliche Änderungen

Wenn die Beschichtung bei bewegten Substraten erfolgt, wird die Schicht immer wieder (in Intervallen) unter dem Sputtertarget durchgefahren, das heißt, die Schicht "sieht" ein örtlich variables Sputterplasma, das sich in Abhängigkeit vom Ort der Schicht im Beschichtungsraum ändert.

### b) Zeitliche Änderung

Eine zeitliche Änderung des Sputterplasmas macht sich dann bemerkbar, wenn sich $I_{inj}$ bei einer bestimmten Stellung der Schicht in Bezug zaf das Target von Durchgang zu Durchgang der Schicht unter dem Target ändert. Meßtechnisch ist diese zeitliche Änderung erfaßbar, entweder durch Messung von $I_{inj}$ an einer oder mehreren Stellen unter dem Target und Vergleich der Einzelmeßwerte von Durchgang zu Durchgang, oder Berechnung des Integrals (Fläche) zus $I_{inj}$ und dem zwischen den Einzelmessungen von $I_{inj}$ zurückgelegten Weg und Vergleich dieses Integralwertes.

Wenn die Schicht (Substrat) zu einer drehbaren Palette liegt und jede Sekunde zum Beispiel ein Meßzyklus (Messung nach Lösungsweg a oder b) erfolgt, so legt die Schicht pro Sekunde den Weg X zurück; zu jedem Wegstück $X_i$ erhält man dann einen injizierten Stromwert $I_{inj}$.

Der Integral-Vergleichswert ergibt sich dann durch: $V = \int I_{inj} \cdot d_x$, wobei der "Weg" über den integriert wird, festgelegt sein kann, als der Weg der Schicht unter dem Target, jedes andere beliebige Wegstück oder sogar eine ganze Umdrehung der Palette sein kann. Die Integration kann mit den bekannten numerischen Verfahren erfolgen, zum Beispiel mit Hilfe der Simpson-Formel. Der Vergleich des Integralwertes ergibt eine größere Genauigkeit als der Vergleich von Einzelwerten von $I_{inj}$. Beim Cosputtern ergibt sich beim Integrieren über den Weg unter jedem einzelnen Target die Änderung der Sputterrate pro Target, beim Integrieren über den Weg einer ganzen Paletten-Umdrehung die Änderung der gesamten Sputterleistung. Hiermit ist es möglich, während der Herstellung von Legierungsschichten zu überwachen, ob Änderungen in der Legierungszusammensetzung auftreten.

Diese Kontrolle der Sputterrate (Konzentration) ist für die Herstellung von Schichten zur Verwendung in Halbleiterbauelementen von größter Bedeutung, da hier die Schichteigenschaften nur in sehr engen Grenzen variieren dürfen.

Diese Detektion von Änderungen in der Sputterrate kann auch für eine Steuerung der Sputterrate verwendet werden.

Der Wert der festgestellten Änderung von $I_{inj}$ oder $\int I_{inj} \cdot d_x$ kann dabei als Regelgröße verwendet werden, die ein Steuersignal erzeugt, mit Hilfe der die Leistungsversorgung für das Target geändert wird (Proportional-Regler).

Im folgenden wird die Erfindung anhand von Ausführungsbeispielen und der Figuren 2 bis 4 noch näher beschrieben. Dabei zeigen

die Figuren 2 und 3 die Änderung des gemessenen Schichtwiderstandes ($R_M$, $R_{M1}$, $R_{M2}$), der injizierten Spannung $U_{inj}$ des wahren Schichtwiderstandes $R_W$ und des injizierten Stromes $I_{inj}$ in Abhängigkeit vom Ort, wobei die Figuren 2 (2a, 2b, 2c) den Sputtermode : DC-Magnetron-Sputtern und

die Figuren 3 (3a, 3b, 3c) den Sputtermode: HF-Dioden-Sputtern betreffen.

Die Figur 4 zeigt im Diagramm die injizierten Ströme in Abhängigkeit vom Ort und der Targetleistung.

**Ausführungsbeispiele:**

Die in dem Aufsatz von N. M. Mayer in Siemens Forschungs- und Entwicklungs-Bericht, Bd. 11 (1982), S. 322 - 326, beschriebene telemetrische Widerstandsmeßapparatur kann wie folgt modifiziert werden:

| Kanal | Widerstandsmeßkanal | Meßstrom |
|---|---|---|
| 1 | 0-1 | 20 mA |
| 2 | 0-10 | 2 mA |
| 3 | 0-100 | 5 mA |
| 4 | 0-1 000 | 1 mA |
| 5 | 0-10 000 | 100 µA |
| 6 | -200 mV bis +200 mV | - |
| 7 | Für Temperaturmeßzwecke | |
| 8 | Für Temperaturmeßzwecke | |

Die Messung erfolgt in der Weise, daß alle 1/10 sec der Meßstrom des nächsten Kanals durch die Schicht geschickt wird und dann der Widerstandswert oder bei Kanal 6 die injizierte Spannung gemessen wird. Dieses Abtasten aller Kanäle erfolgt zyklisch, das heißt, daß nach Kanal 8 wieder mit Kanal 1 begonnen wird.

Bei Verwendung der Kanäle 5 und 6 unter Zugrundelegung des Lösungsweges 1 erfolgen die beiden notwendigen Messungen innerhalb von 0,2 sec, analog ist es bei Verwendung der Kanäle 4 und 5 unter Zugrundelegung des Lösungsweges 2 und einer Schicht mit einem elektrischen Widerstand von kleiner 1000 $\Omega$.

Als Sputteranlage wurde die Anlage von Perkin-Elmer verwendet, die eine Hochvakuumschleuse besitzt und bei der während der Beschichtung die Substrate auf einer sich drehenden Palette liegen (Durchmesser Target: 20 cm, Substrate liegen auf einen Radius von 20 cm).

**1. Ausführungsbeispiel:**

Sputtermethode: DC-Magnetron (Gleichstrom)
Material: Tantal.
Leistung am Target: 1020 Watt
Zeit für eine Palettenumdrehung: 4.4 sec

**Lösungsweg 1:**

Verwendung eines bekannten Meßstromes; Messung des ektrischen Widerstandes $R_M$ und der Spannung $U_{inj}$ ohne Meßstrom.

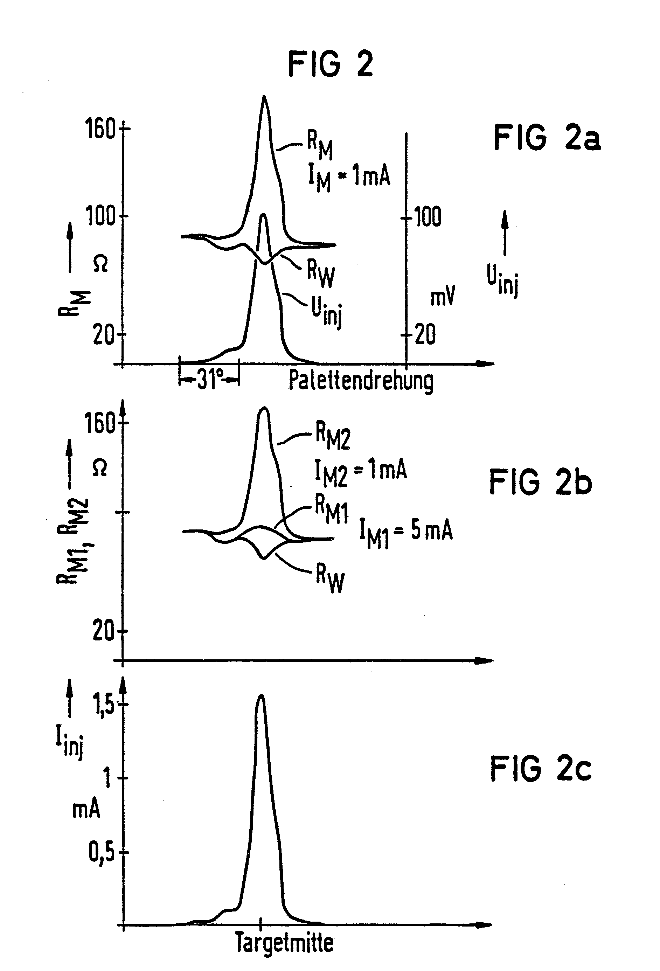

Das Ergebnis von Messungen für einen Durchgang der Schicht unter dem Target zeigt die Tabelle 2 sowie die Figur 2a. Wenn die Schicht in das Sputterplasma hineinbewegt wird, steigen der gemessene Widerstand und die Spannung zunächst an und fallen dann wieder ab, wenn die Schicht das Sputterplasma wieder verläßt (örtliche Änderung des Plasmas im Beschichtungsraum).

**Tabelle 2**

| $R_M$ [Ω] $I_M = 0.1$ mA | $U_{inj}$ [mV] | RW[Ω] | $I_{inj}$ [µA] |
|---|---|---|---|
| 952 | 0.9 | 943 | 10 |
| 1026 | 10.5 | 921 | 114 |
| 1267 | 39.1 | 876 | 446 |
| 1282 | 42.7 | 855 | 500 |
| 1140 | 34.1 | 799 | 427 |
| 913 | 11.2 | 801 | 143 |
| 752 | -3.3 | 785 | -42 |
| $I_M = 1$ mA | | | |
| 942 | 0.9 | 941.1 | 9.6 |
| 921 | 10.5 | 910.5 | 115 |
| 906 | 39.1 | 866.9 | 451 |
| 881 | 42.7 | 838.3 | 509 |
| 840 | 34.1 | 805.9 | 423 |
| 804 | 11.2 | 792.8 | 141 |
| 778 | -3.3 | 781.3 | -42 |

**Lösungsweg 2:**

Verwendung zweier bekannter Meßströme; Messung zweier elektrischer Widerstände. Das Ergebnis von Messungen für einen Durchgang der Schicht unter dem Target zeigt die Tabelle 3 sowie Figur 2b.

**Tabelle 3**

| $R_{M1}$ [Ω] $I_{M1} = 0.1$ mA | $R_{M2}$ [Ω] $I_{M2} = 1$ mA | $R_W$[Ω] | $I_{inj}$[µA] |
|---|---|---|---|
| 952 | 942 | 940.9 | 10 |
| 1026 | 921 | 909.3 | 130 |
| 1267 | 906 | 865.9 | 460 |
| 1282 | 881 | 836.4 | 530 |
| 1140 | 840 | 806.7 | 410 |
| 913 | 804 | 791.9 | 150 |
| 752 | 778 | 780.9 | -40 |

Den Verlauf des in die Schicht durch das Plasma injizierten Stroms zeigt Figur 2c. Direkt unter dem Sputtertarget ist demnach der Einfluß am größten.

**2. Ausführungsbeispiel:**

Sputtermethode: HF (Hochfrequenz)
Material: Wolfram
Leistung am Target: 1900 Watt
Zeit für eine Palettenumdrehung: 6.4 sec

**Lösungsweg 1, Tabelle 4**

| $R_M$ [Ω] | $U_{inj}$ [mV] | $R_w$[Ω] | $I_{inj}$ [mA] |
|---|---|---|---|
| 1597 | 145.1 | 146 | 0.994 |
| 1336 | 119.3 | 143 | 0.834 |
| 1197 | 105.0 | 147 | 0.714 |
| 1228 | 108.2 | 146 | 0.741 |
| 1626 | 149.6 | 130 | 1.151 |
| 1941 | 181.7 | 124 | 1.465 |

6

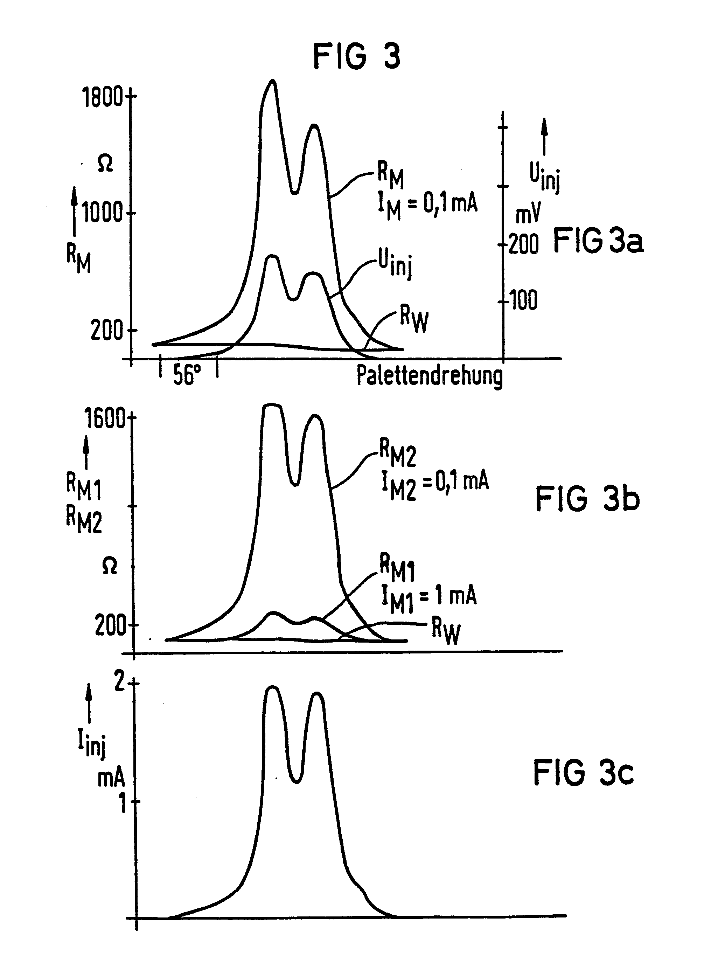

Den Verlauf der Meßwerte bei einem Durchgang der Schicht unter dem Target zeigt Figur 3a und b sowie die Tabelle 5. Der Verlauf des injizierten Stromes zeigt Figur 3c. Im Gegensatz zum Einfluß des Plasmas im Falle des DC-Magnetrons, tritt beim HF-Sputtern ein Minimum des Einflusses auf, wenn sich die Schicht genau unter dem Target befindet.

**Lösungsweg 2, Tabelle 5**

| $R_{M1}[\Omega]$ $I_{M1} = 1mA$ | $R_{M2}[\Omega]$ $I_{M2} = 0.1$ mA | $R_W[\Omega]$ | $I_{inj}$ [mA] |
|---|---|---|---|
| 291 | 1597 | 145.9 | 0.995 |
| 263 | 1336 | 143.8 | 0.829 |
| 247 | 1197 | 141.4 | 0.747 |
| 252 | 1228 | 143.6 | 0.755 |
| 281 | 1626 | 131.6 | 1.135 |
| 314 | 1941 | 133.2 | 1.357 |

Verwendung von 3 bekannten Meßströmen.

**Tabelle 6**

| $R_{M1}[\Omega]$ $I_{M1} = 5mA$ | $R_{M2}[\Omega]$ $I_{M2} = 1mA$ | $R_{M3}[\Omega]$ $I_{M3} = 0.1mA$ | $R_{W12}[\Omega]$ | $R_{W13}[\Omega]$ | $R_{W23}[\Omega]$ | $R_W[\Omega]$ | $I_{inj}[mA]$ |
|---|---|---|---|---|---|---|---|
| 86.6 | 97 | 203 | 84 | 84.2 | 85.2 | 84.47 | 0.126 |
| 87.0 | 99 | 230 | 84 | 84.1 | 84.4 | 84.17 | 0.135 |
| 87.5 | 101 | 264 | 84.1 | 83.9 | 82.9 | 83.63 | 0.231 |
| 88.7 | 105 | 310 | 84.6 | 84.2 | 82.2 | 83.67 | 0.303 |
| 90.6 | 118 | 405 | 83.8 | 84.2 | 86.1 | 84.7 | 0.348 |
| 92.7 | 129 | 552 | 83.6 | 83.3 | 82.0 | 82.97 | 0.586 |
| 95.8 | 145 | 735 | 83.5 | 82.8 | 79.4 | 81.9 | 0.848 |
| 83.8 | (84) | (85) | | | | 83.8 | - |
| 83.8 | (84) | (84) | | | | | |

Die Tabelle 6 zeigt, daß der Wert von $R_W$ während des Sputterns dem gemessenen Widerstandswert entspricht, den man nach Ausschalten des Sputtertargets (-plasmas) erhält. Als Folge der reaktiven Oberfläche der Ta-Schicht kommt es nach dem Abschalten des Sputtervorgangs zu einer Belegung der Oberfläche mit Fremdatomen (Ar, $O_2$, usw.), wodurch der Schichtwiderstand wieder leicht ansteigt (siehe die Werte im unteren Teil der Tabelle 6).

**Tabelle 7**

**Kombination von Lösungsweg 1 und Lösungsweg 2**

| $R_{M1}[\Omega]$ | $R_{M2}[\Omega]$ | $U_{inj}[mV]$ | $R_{W1}[\Omega]$ | $R_{W2}[\Omega]$ | $R_W[\Omega]$ | $I_{inj}[mA]$ |
|---|---|---|---|---|---|---|
| 341 | 2017 | 185.8 | 155.2 | 154.8 | 155 | 1.2 |
| 265 | 1241 | 108.2 | 156.8 | 156.6 | 156.7 | 0.69 |
| 233 | 938 | 78.6 | 154.4 | 154.7 | 154.6 | 0.51 |
| 209 | 698 | 54.7 | 153.3 | 153.6 | 153.5 | 0.36 |

Die Beispiele 1 und 2 zeigen, daß das Verfahren unabhängig von der Sputtermethode DC oder HF mit ihren unterschiedlichen Plasmen funktioniert. Auch das gesputterte Material ist hierbei ohne Einfluß.

**Ausführungsbeispiel:**

Sputtermethode: DC-Magnetron-Cosputtern
Material: Tantal, Silizium (P-dotiert)
Leistung: gesamt: 2610 Watt; Tantal: 950 Watt; Silizium: 1660 Watt.
Zeit für eine Palettenumdrehung: 4.4 sec

Das Ergebnis von Messungen in einem Plasma, das von 2 Targets erzeugt wird, zeigt die Tabelle 8 während die Schicht unter den beiden Targets hindurchbewegt wird. Der Einfluß der beiden Targets (Plasmen) ist deutlich zu sehen. Zuerst kommt das Tantal-Target (oberer Teil der Tabelle 8) und dann das Silizium-Target (unterer Teil der Tabelle 8).

Lösungsweg 1: $R_{M1}$ und $U_{inj}$ ergeben $R_{W1}$

Lösungsweg 2: $R_{M1}$ und $R_{M2}$ ergeben $R_{W2}$

**Tabelle 8**

| $R_{M1}[\Omega]$ $I_{M1} = 1$ mA | $R_{M2}[\Omega]$ $I_{M2} = 0.1$ mA | $U_{inj}[mV]$ | $R_{W1}$ $[\Omega]$ | $R_{W2}$ $[\Omega]$ | $I_{inj}[\mu A]$ |
|---|---|---|---|---|---|
| 637 | 681 | 4.9 | 632 | 632 | 8 |
| 645 | 774 | 14.0 | 631 | 630 | 24 |
| 654 | 962 | 34.5 | 620 | 619 | 56 |
| 680 | 1385 | 78.1 | 602 | 602 | 130 |
| 672 | 1927 | 139.8 | 532 | 533 | 262 |
| 689 | 1871 | 131.7 | 557 | 558 | 236 |
| 660 | 1136 | 52.4 | 608 | 607 | 87 |
| 639 | 882 | 27.5 | 612 | 612 | 44 |
| 661 | 1126 | 51.3 | 610 | 609 | 85 |
| 653 | 1600 | 105.4 | 548 | 548 | 192 |
| 615 | 1543 | 103.8 | 511 | 512 | 201 |
| 583 | 1233 | 72.4 | 511 | 511 | 141 |
| 601 | 752 | 16.5 | 585 | 584 | 29 |
| 615 | 662 | 5.0 | 610 | 610 | 9 |
| 619 | 659 | 4.6 | 614 | 615 | 7 |

Als Folge Oberflächenbelegungen steigt der Schichtwiderstand nach dem Aufsputtern der Ta-Teilschicht (oberer Teil der Tabelle) wieder an, beim Auftrag von Silizium (unterer Teil der Tabelle) finden zunächst Diffusionsvorgänge statt, wodurch der Schichtwiderstand zunächst wieder sinkt, um dann wieder als Folge von Oberflächenbelegung durch Fremdatome anzusteigen.

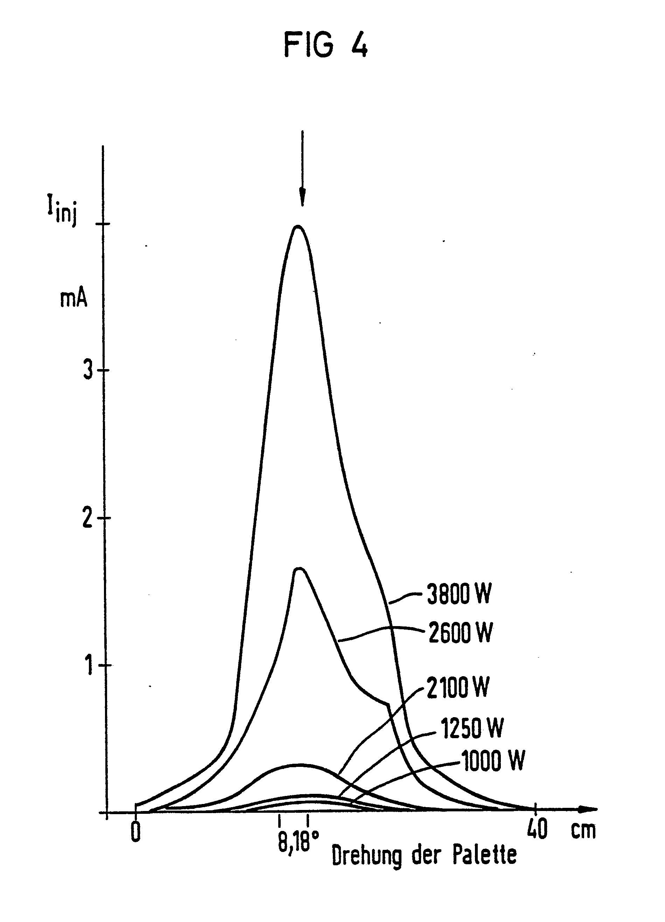

### 4. Ausführungsbeispiel (darstellt durch Figur 4):

Sputtermethode: DC-Magnetron

Material: Tantal

Zeit für eine Palettenumdrehung: 4.4 sec

Von Messung zu Messung dreht sich die Palette um 8.18°, die Schicht bewegt sich dabei um 2.86 cm. In Figur 4 sind die injizierten Ströme als Funktion des Weges der Schicht aufgetragen für unterschiedliche Sputterleistungen. Zum Vergleich der Änderungen von Einzelwerten von $I_{inj}$ wurde die mit einem Pfeil markierte Palettenstellung gewählt. Zur Berechnung von $\int I_{inj} \cdot dx$ (entspricht der Fläche, die durch die Kurve, die horizontale Achse und die Integrationsgrenzen begrenzt wird) wurde die numerische Integrationsmethode nach Simpson gewählt. Es wird über 15 Messungen entsprechend einem Weg von 40.04 cm integriert. Die Strecke unter dem Target beträgt etwa 20 cm. Das Ergebnis zeigt die Tabelle 9.

**Tabelle 9**

| Leistung Watt | Rate [nm/min] | $I_{inj}$ [mA] | $\int I_{inj} \cdot dx$ 40cm |
|---|---|---|---|
| 3800 | 50 | 3.9759 | 46 |
| 2600 | 38.7 | 1.632 | 19.61 |
| 2100 | 29.5 | 0.3148 | 4.08 |
| 1250 | 19 | 0.1124 | 1.52 |
| 1000 | 16 | 0.0708 | 0.88 |

Änderungen in der Leistung haben bekanntlich eine Änderung in der Sputterrate zur Folge. Diese geänderte Sputterrate ist deutlich bestimmbar durch eine Änderung im Strom, der durch das Plasma in die Schicht injiziert wird. Aus Gründen der Genauigkeit kann es sinnvoll sein, als Vergleichswert nicht den injizierten Strom von nur einer Stelle zu vergleichen, sondern die Summe über mehrere Messungen oder insbesondere das beschriebene Integral (= Fläche) als Vergleichswert zu verwenden.

## 5. Ausführungsbeispiel:

Sputtermethode: HF (Hochfrequenz)
Material: Wolfram
Zeit für eine Palettenumdrehung: 6.4 sec
Von Messung zu Messung dreht sich die Palette um 5.6°, die Schicht bewegt sich dabei um 1.96 cm.
Die Integration erfolgt wiederum nach der Methode von Simpson, der Integrationsweg beträgt 17.64 cm. Das Ergebnis zeigt die Tabelle 10.

**Tabelle 10**

| Leistung Watt | Rate [nm/min] | $I_{inj}$ [mA] | $\int I_{inj} \cdot d_x \swarrow$ 17.64 cm |
|---|---|---|---|
| 1900 | 13.7 | 1.97 | 31.32 |
| 1000 | 7.2 | 1.4 | 21.09 |

Eine Änderung der Sputterrate hat wiederum eine Änderung im Strom zur Folge, der durch das Plasma in die Schicht injiziert wird.

## 6. Ausführungsbeispiel:

Sputtermethode: DC-Magnetron, Co-Sputtern
Material: Tantal, Silizium (P-dotiert)
Zeit für eine Palettenumdrehung: 4.4 sec
Jedes Target besitzt eine eigene Energieversorgung, so daß die Leistung für jedes Target unabhängig vom anderen verändert werden kann. Im Versuch werden die Ta-Target-Leistung konstant gehalten, während die Leistung am Si-Target variiert wird. Hierdurch werden Schichten mit unterschiedlicher Konzentration hergestellt.
Die Integration erfolgt über 11.44 cm (5 Werte von $I_{inj}$) direkt unter dem Si-Target:

**Tabelle 11**

| Konz. Si Rest Ta Mol% | $I_{inj}$ mA | $I_{inj} \cdot dx$ 11.44 cm |
|---|---|---|
| 29.5 | 0.0617 | 0.452 |
| 33.0 | 0.0429 | 0.315 |
| 35.0 | 0.0338 | 0.297 |
| 36.5 | 0.0303 | 0.256 |
| 37 | 0.0272 | 0.242 |

Die Leistung am Si-Target variiert hierbei von 650 bis 1000 Watt. In diesem Fall, in dem die Leistung (= Rate) nur wenig verändert wird, ist der Vergleich der Integralwerte besonders geeignet. Es ergibt sich ein eindeutiger Zusammenhang zwischen der Si-Konzentration (= Sputterrate) und $I_{inj}$, bzw. $\int Inj \cdot dx$.

## Patentansprüche

1. Verfahren zur Messung des elektrischen Widerstandes $R_W$ von unter dem Einfluß eines Plasmas hergestellten, dünnen, metallischen Schichten während ihrer Herstellung durch eine Gleichstromwiderstandsmessung nach dem Prinzip der Zweipunkt- oder Vierpunkt-Meßmethode, <u>dadurch gekennzeichnet</u>, daß der elektrische Widerstand $R_M$ oder der Spannungsabfall $U_M$ über die Schicht bei mindestens einem Meßstrom $I_M$ bestimmt wird und unmittelbar davor oder danach die an den Meßkontakten anliegende Spannung $U_{inj}$, die über die Schicht abfällt, gemessen wird, wenn kein Meßstrom durch die Schicht geschickt wird und sich der elektrische Widerstand $R_W$ der Schicht bei Bestimmung des elektrischen Widerstandes $R_M$ aus $R_W = \frac{R_M \cdot I_M - U_{inj}}{I_M}$ und
bei Bestimmung des Spannungsabfalls $U_M$ über die Schicht aus $R_W = \frac{U_M - U_{inj}}{I_M}$
ergibt, wobei sich bei Verwendung von mehr als zwei Meßströmen $I_M$ der elektrische Widerstand $R_W$ als Mittelwert ergibt.

9

2. Verfahren zur Messung des elektrischen Widerstandes $R_W$ von unter dem Einfluß eines Plasmas hergestellten, dünnen, metallischen Schichten während ihrer Herstellung durch eine Gleichstromwiderstandsmessung nach dem Prinzip der Zweipunkt- oder Vierpunkt-Meßmethode, dadurch gekennzeichnet, daß der elektrische Widerstand $R_{Mi}$ oder der Spannungsabfall $U_{Mi}$ über die Schicht bei mindestens zwei unterschiedlichen Meßströmen $I_{Mi}$ bekannter Größen bestimmt wird, wobei die Meßströme entsprechend dem Schichtwiderstand gewählt werden und die Differenz zwischen den verwendeten Meßströmen im Bereich des Verhältnisses 2 bis 100 gewählt wird und sich der elektrische Widerstand $R_W$ der Schicht bei Bestimmung des elektrischen Widerstandes $R_{Mi}$ aus

$$R_W = \frac{R_{M1} \cdot I_{M1} - R_{M2} \cdot I_{M2}}{I_{M1} - I_{M2}}$$

und bei Bestimmung des Spannungsabfalls $U_{Mi}$ über die Schicht aus

$$R_W = \frac{U_{M1} - U_{M2}}{I_{M1} - I_{M2}}$$

ergibt, wobei sich bei Verwendung von mehr als zwei Meßströmen $I_M$ der elektrische Widerstand $R_W$ als Mittelwert ergibt.

3. Verfahren nach Anspruch 2, dadurch gekennzeichnet, daß ein Verhältnis der Meßströme von 10 gewählt wird.

4. Verfahren nach Anspruch 2 und/oder 3, dadurch gekennzeichnet, daß die Meßströme in gleicher Richtung fließen.

5. Verfahren nach Anspruch 1 bis 4, dadurch gekennzeichnet, daß die Messungen in einem Zeitintervall von 0,01 bis 1 Sekunde, vorzugsweise von 0,2 Sekunden, durchgeführt werden.

6. Anwendung des Meßverfahrens nach einem der Ansprüche 1 bis 5 zur Messung des in die Schicht durch das Plasma injizierte Elektronen- und Ionenstromes $I_{inj}$, der sich aus

$$I_{inj} = \frac{I_M (R_M - R_W)}{R_W}$$ ergibt.

7. Anwendung des Meßverfahrens nach einem der Ansprüche 1 bis 6 zur Bestimmung von Änderungen in der Sputterrate und/oder zur Bestimmung von Änderungen in der Konzentration bei der Herstellung von Legierungsschichten, in dem die zeitliche und/oder örtliche Änderung des in die Schicht durch das Plasma induzierten Elektronen- und Ionenstromes $I_{inj}$ gemessen wird, der von der Sputterrate abhängt.

## Claims

1. A method of measuring electrical resistance $R_W$ of thin, metallic layers during their production under the influence of a plasma by means of d.c. resistance measurement in accordance with the principle of two-point or four-point measurement, characterised in that the electrical resistance $R_M$ or the voltage drop $U_M$ across the layer is determined with at least one measuring current $I_M$ and immediately before or after the voltage $U_{inj}$ which is connected to the measuring contacts and which drops across the layer is measured when no measuring current is passing through the layer and the electrical resistance $R_W$ of the layer is calculated in accordance with

$$R_W = \frac{R_M \cdot I_M - U_{inj}}{I_M}$$

if the electrical resistance $R_M$ is predetermined, and in accordance with

$$R_W = \frac{U_M - U_{inj}}{I_M}$$

if the voltage drop $U_M$ across the layer is predetermined, where the electrical resistance $R_W$ is the mean value when more than two measuring currents $I_M$ are used.

2. A method of measuring the electrical resistance $R_W$ of thin, metallic layers during the production thereof under the influence of a plasma by a d.c. resistance measurement in accordance with the principle of two-point or four-point measurement, characterised in that the electrical resistance $R_{Mi}$ or the voltage drop $U_{Mi}$ across the layer is determined with at least two different measuring currents $I_{Mi}$ of known values, where the measuring currents are selected in accordance with the layer resistance and the difference between the measuring currents used is selected in the region of the ratio 2 to 100, and the electrical resistance $R_W$ of the layer is calculated in accordance with

$$R_W = \frac{R_{M1} \cdot I_{M1} - R_{M2} \cdot I_{M2}}{I_{M1} - I_{M2}}$$

if the electrical resistance $R_{Mi}$ is predetermined and is calculated in accordance with

$$R_W = \frac{U_{M1} - U_{M2}}{I_{M1} - I_{M2}}$$

if the voltage drop $U_{Mi}$ across the layer is predetermined, where the electrical resistance $R_W$ is the mean value when more than two measuring currents $I_M$ are used.

3. A method as claimed in Claim 2, characterised in that the selected ratio of the measuring currents is 10.

4. A method as claimed in Claim 2 and/or 3, characterised in that the measuring currents flow in the same direction.

5. A method as claimed in Claims 1 to 4, characterised in that the measurements are carried out at time intervals of from 0.01 to 1 second, preferably 0.2 seconds.

6. Application of the method of measurement claimed in one of Claims 1 to 5 for measuring the electron and ion current $I_{inj}$ injected through the plasma and calculated in accordance with

$$I_{inj} = \frac{I_M (R_M - R_W)}{R_W}$$

10

7. Application of the method of measurement claimed in one of Claims 1 to 6 for determining changes in the sputter rate and/or changes in the concentration in the production of alloy layers, in which a measurement is carried out of the time and/or local change in the electron and ion current $I_{inj}$ injected into the layer by the plasma and dependent upon the sputter rate.

## Revendications

1. Procédè pour mesurer la résistance électrique $R_W$ de couches métalliques minces fabriquées sous l'influence d'un plasma, pendant leur fabrication, grâce à une mesure de la résistance en courant continu basée sur le principe du procédé de mesure en deux points ou en quatre points, caractérisé par le fait qu'on détermine la résistance électrique $R_M$ ou la chute de tension $U_M$ dans la couche pour au moins un courant de mesure $I_M$ et qu'on mesure, juste avant ou aussitôt après, la tension $U_{inj}$ présente sur les contacts de mesure et qui chute dans la couche, lorsqu'aucun courant de mesure n'est envoyé à travers cette couche, et que la résistance électrique $R_W$ de la couche est fournie, lors de la détermination de la résistance électrique $R_M$, par

$$R_W = \frac{R_M \cdot I_M - U_{inj}}{I_M}$$

et, lors de la détermination de la chute de tension $U_M$ dans la couche, par

$$R_W = \frac{U_M - U_{inj}}{I_M}$$

auquel cas on obtient, lors de l'utilisation de plus de deux courants de mesure $I_M$, la résistance électrique $R_W$ en tant que valeur moyenne.

2. Procédè pour mesurer la résistance électrique $R_W$ de couches métalliques minces fabriquées sous l'influence d'un plasma, pendant leur fabrication, grâce à une mesure de la résistance en courant continu basée sur le principe du procédé de mesure en deux points ou en quatre points, caractérisé par le fait qu'on détermine la résistance électrique $R_{Mi}$ ou la chute de tension $U_{Mi}$ dans la couche pour au moins deux courants de mesure différents $I_{Mi}$ possédant des intensités connues, les courants de mesure étant choisis en fonction de à la résistance de la couche, et la différence entre les courants de mesure utilisés étant choisie de manière à correspondre à un rapport situé dans la gamme de 2 à 100 et la résistance électrique $R_W$ de la couche étant fournie, lors de la détermination de la résistance électrique $R_{Mi}$, par

$$R_W = \frac{R_{M1} \cdot I_{M1} - R_{M2} \cdot I_{M2}}{I_{M1} - I_{M2}}$$

et, lors de la détermination de la chute de tension $U_{Mi}$ dans la couche, par

$$R_W = \frac{U_{M1} - U_{M2}}{I_{M1} - I_{M2}}$$

auquel cas, lors de l'utilisation de plus de deux courants de mesure $I_M$, la résistance électrique $R_W$ est obtenue sous la forme d'une valeur moyenne.

3. Procédé suivant la revendication 2, caractérisé par le fait qu'on choisit un rapport des courants de mesure égal à 10.

4. Proccédé suivant la revendication 2 et/ou 3, caractérisé par le fait que les courants de mesure circulent dans la même direction.

5. Procédé selon les revendications 1 à 4, caractérisé en ce que les mesures sont exécutées dans un intervalle de temps compris entre 0,01 et 1 seconde et de préférence égal à 0,2 seconde.

6. Application du procédé de mesure suivant l'une des revendications 1 à 5 à la mesure du courant électronique et ionique $I_{inj}$, qui est injecté dans la couche par le plasma et est fourni par

$$I_{inj} = \frac{I_M(R_M - R_W)}{R_W}$$

7. Application du procédé de mesure suivant l'une des revendications 1 à 6 à la détermination de variations de la vitesse de dépôt par pulvérisation et/ou à la détermination de variations de la concentration lors de la fabrication de couches d'alliage, au moyen d'une mesure de la variation dans le temps et/ou de la variation locale du courant électronique et ionique $I_{inj}$ injecté dans la couche par le plasma et qui dépend de la vitesse de dépôt par pulvérisation.

FIG 1

0hm

sec ——

500
375
250
125
0

180  360

# FIG 2

FIG 2a

FIG 2b

FIG 2c

# FIG 3

$R_M$
$I_M = 0,1\,mA$

$U_{inj}$
mV

FIG 3a

$U_{inj}$

$R_W$

56°          Palettendrehung

$R_{M2}$
$I_{M2} = 0,1\,mA$

FIG 3b

$R_{M1}$
$I_{M1} = 1\,mA$

$R_W$

$I_{inj}$
mA

FIG 3c

# FIG 4